Europäisches Patentamt

European Patent Office

Office européen des brevets

(11) Publication number: **0 186 481**
**B1**

(12) **EUROPEAN PATENT SPECIFICATION**

(45) Date of publication of patent specification: **23.05.90**

(21) Application number: **85309388.8**

(22) Date of filing: **20.12.85**

(51) Int. Cl.⁵: **C 23 C 16/40, C 03 C 17/245**

(54) Improved chemical vapor deposition method of producing fluorine-doped tin oxide coatings.

(30) Priority: **28.12.84 US 687067**
**12.11.85 US 797364**
**25.06.85 US 748648**

(43) Date of publication of application:
**02.07.86 Bulletin 86/27**

(45) Publication of the grant of the patent:
**23.05.90 Bulletin 90/21**

(84) Designated Contracting States:
**AT BE CH DE FR GB IT LI LU NL SE**

(56) References cited:
**EP-A-0 158 399**
**US-A-4 293 594**

**THE SOLID FILMS, vol. 109, no. 1, November
1983, pages 71-83, Elsevier Sequoia, NL; J.
MELSHEIMER et al.: "Thin tin oxide films of low
conductivity prepared by chemical vapour
deposition"**

(73) Proprietor: **M & T CHEMICALS, INC.
One Woodbridge Center
Woodbridge, New Jersey 07095 (US)**

(72) Inventor: **Lindner, Georg H.
Haydnlaan, 10
NL-4384 KV Vlissingen (NL)**

(74) Representative: **Ford, Michael Frederick et al
MEWBURN ELLIS & CO. 2/3 Cursitor Street
London EC4A 1BQ (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

Background of the invention
1. Field of the invention

This invention relates to tin oxide coatings, and more particularly, to an improved method of producing fluorine-doped tin oxide coatings by chemical vapor deposition.

2. Description of the prior art

Fluorine-doped tin oxide coatings are known to impart useful properties to many different substrate surfaces, including glass, ceramics, metals and elemental filaments. Such coated substrates find use as heat reflective elements, in energy efficient windows and in opto-electronic and semiconductor devices.

Chemical vapor deposition of tin oxide coatings has been described in the literature, see, for example, United States Patents 3,677,814; 3,949,146; 4,130,673; 4,146,657; 4,213,594; 4,265,974; Thin Solid Films 77, 51—63 (1981); 65—66; and J. Electrochem. Soc. 122, 1144 (1975).

The chemical vapor deposition method described in the prior art suffers from one or more disadvantages in that the process conditions, or compositions used, or the properties of the resulting tin oxide coatings, are not entirely satisfactory for certain commercial applications. For example, where the product is an energy efficient window, success has been limited by the relatively high and variable sheet resistance of the coatings obtained in the process, and the low deposition rates.

Kane in U.S. Patent No. 3,949,146 describes chemical vapor deposition of tin oxide coatings from dibutyltin diacetate, bis(tri-n-propyl)tin oxide or bis(tri-n-butyl)tin oxide doped with antimony. However, there is no disclosure of a method of producing a low sheet resistance fluorine-doped coating whose resistance is independent of process variables.

A chemical deposition method also is disclosed by Kato in U.S. Patent 4,500,567. This process uses a gaseous mixture of monobutyltin trichloride and a halodifluoromethane which is formed from separate gaseous streams of each reactant. The gaseous mixture then is deposited onto a glass surface. However, in this method the electrical properties of the coating are not adequate, and the deposition times are long.

As will be apparent from the above-described review of the prior art, there is a need for an improved chemical vapor deposition process of making fluorine doped tin oxide coatings, particularly a process which will provide such coatings having a constant and minimum sheet resistance under a range of process conditions.

Summary of the invention

In accordance with the invention, there is provided herein an improved chemical vapor deposition method for forming fluorine-doped tin oxide coatings using a liquid coating composition which includes a reactive organic fluorine dopant and an organotin compound. The method is carried out under a defined set of process conditions such that the coating produced has a minimum and constant sheet resistance which is substantially independent of temperature. The variables in this process are the concentrations, in the vapor phase, of carrier gas, water, organic fluorine dopant and organotin compound. These concentrations are related by a parameter M, which is defined by the equation:

$$M = \frac{(AIR) \quad (H_2O)}{(OFD) \quad (O)},$$

where

(AIR), ($H_2O$), (OFD) and (O) are the molar proportions of carrier gas, water, organic fluorine dopant and organotin compound in the vapor mixture.

Suitably, M has a value of 50,000 or less, preferably 20,000 or less. At these M values, the deposited tin oxide coating has a minimum and constant sheet resistance which is substantially independent of deposition temperature. At M values higher than those proscribed herein, the sheet resistance increases substantially with increasing M and increases with deposition temperature.

The chemical vapor deposition process is carried out using a liquid coating composition which comprises 1—30 wt.% of the organic fluorine dopant, and 70—99% of the organotin compound. A preferred composition is 2—10% of the organic fluorine dopant and 90—98 wt.% of the organotin compound. The composition may contain up to 10 wt.% of a polar organic solvent.

Deposition may be carried out on glass to produce a fluorine-doped tin oxide coating of a thickness of 180—210 nm which has a minimum and constant sheet resistance of about 25 ohms/sq. for M values which are 50,000 or below, preferably 20,000 or below.

Brief description of the drawings

Fig. 1 is a schematic illustration of an apparatus for carrying out a suitable chemical vapor deposition process.

Fig. 2 is a graph of sheet resistance vs. M values for tin oxide coatings produced in accordance with the process of this invention.

Detailed description of the invention

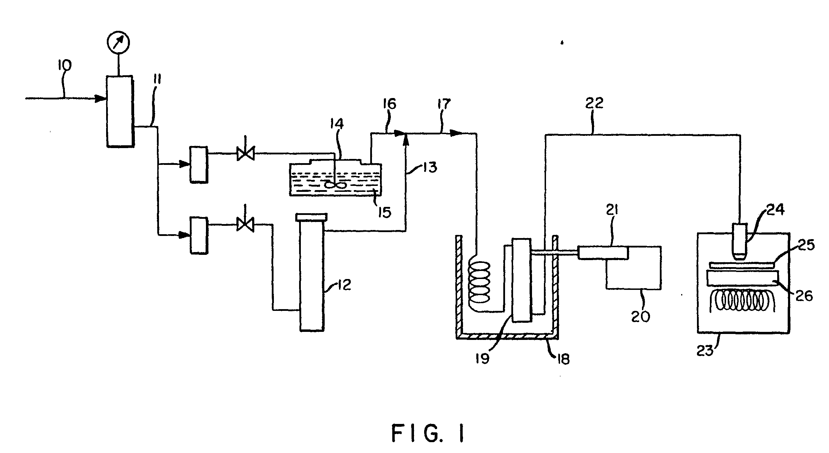

Referring now to Fig. 1, there is shown a diagrammatic representation of an apparatus suitable for carrying out the chemical vapor deposition process of the present invention. A carrier gas 10 which includes oxygen, with air being preferred, is metered through a feed line 11 and through an air dryer tower 12 to provide a stream 13 of dry air. A separate air stream is directed through a humidifier 14 containing a suitable quantity of water 15 to provide a wet air stream 16 at a desired relative humidity. Thereby a wet air stream 17, is passed through an evaporator 18 containing vessel 19 which holds a liquid coating composition supplied to evaporator 18 by syringe pump 20 and syringe 21. The air stream is heated from an oil bath (not shown) to a desired vaporization temperature.

The vaporized liquid coating composition in the air stream 22 then travels to a deposition chamber 23 having a coating nozzle 24 in which a substrate 25 is mounted on a heated plate 26. After deposition of the desired coating the gaseous by-products of the deposition are exhausted.

The liquid coating composition in the process of the invention comprises:

a) 1—30 wt.% of a reactive organic fluorine dopant compound where at least one fluorine atom is located alpha or beta to a functional group wherein carbon is bonded to oxygen selected from carboxylic acid, anhydride, ester, alcohol, ketone, acid halide or ether; and

b) 70—99 wt.% of an organotin compound which is an alkyltin trichloride, a dialkyltin dichloride, an alkyldichlorotin acetate, an alkyl chlorotindiacetate, or an ester tin trichloride, or tin tetrachloride.

Accordingly, suitable functional groups and reactive organic fluorine dopants include the following:

Carboxylic acids
trifluoroacetic acid
chlorodifluoroacetic acid
difluoroacetic acid
heptafluorobutyric acid
pentafluoropropionic acid
3-trifluoromethylcrotonic acid

Anhydrides
trifluoroacetic anhydride
heptafluorobutyric anhydride
pentafluoropropionic anhydride
chlorodifluoroacetic anhydride
perfluoroglutaric anhydride
perfluorosuccinic anhydride

Esters
ethyl trifluoroacetate
butyl trifluoroacetate
ethyl bromodifluoroacetate
ethyl chlorofluoroacetate
methyl pentafluoropropionate
methyl heptofluorobutyrate
methyl trifluoroacetate
methyl perfluorobuten-3-oate
2,2,2-trifluoroethyltrifluoroacetate
1,1,1-trifluoroisopropylacetate

Alcohols
2,2,2-trifluoroethanol
1H,1H-heptafluorobutanol-1
3,3,4,4,5,5,5-heptafluoropentanol-2
heptafluoroisopropanol
hexafluoro-2-methylisopropanol
1H,1H,5H-octafluoro-1-pentanol
perfluoro-t-butanol
2-trifluoromethylpropanol-2
1,1,1-trifluoropropanol-2

Ketones
ethyl 4,4,4-trifluoroacetoacetate
1,1,1-trifluoroacetylacetone
bis(perfluoroisopropyl)ketone
3-bromo-1,1,1-trifluoropropanone
ethyl 4,4,4-trifluoroacetoacetate

hexafluoroacetylacetone
pentafluoroethyl ethyl ketone
1,1,1-trifluoroacetone
methyl heptafluoropropyl ketone

Acid halides
heptafluorobutyryl chloride
perfluoroglutaryl fluoride
perfluoroctanoyl chloride
perfluorosuccinyl chloride

Ethers
2-chloro-1,1,2-trifluoroethyl methyl ether
2-chloro-1,1,2-trifluoroethyl ethyl ether

Representative reactive organic fluorine dopants include trifluoroacetic acid, trifluoroacetic anhydride, ethyl trifluoroacetoacetate, trifluoroethanol, ethyl trifluoroacetate, pentafluoropropionic acid, 2-chloro-1,1,2-trifluoroethyl methyl ether, 1,1,1-trifluoroacetylacetone and heptafluorobutyryl chloride.

Typical organotin compounds include monobutyltin trichloride, methyltin trichloride, isobutyltin trichloride, dibutyltin dichloride, butyldichlorotin acetate, butylchlorotin diacetate, carbethoxyethyltin trichloride. Tin tetrachloride also may be used as the tin compound.

In a preferred form of the invention, the liquid coating composition includes 2—10 wt.% of the organic fluorine compound, and 90—98 wt.% of the organotin compound.

The liquid coating composition of the invention may include also a polar organic compound, in an amount of about 1—10 wt.% of the composition, which will insure stability of the liquid composition at low temperatures. When the polar organic liquid is present, the liquid coating composition may include 2—10 wt.% of the organic fluorine dopant, 80—97 wt.% of the organotin compound and 1—10 wt.% of the polar organic liquid.

In a preferred form of the invention the organic fluorine dopant is trifluoroacetic acid, trifluoroacetic anhydride, or ethyl trifluoroacetoacetate, and the organotin compound is monobutyltin trichloride.

The vaporization temperature in the process suitably ranges from about 100° to about 400°C, and preferably about 150° to 250°C. The substrate temperature ranges from about 400° to about 700°C, and preferably about 550° to about 650°C.

The carrier gas is an oxygen-containing gas which may be air, or a mixture of oxygen and an inert gas, and is preferably air.

The carrier gas contains water vapor in the process of the invention.

The substrate to be coated may be glass, ceramics, solid state materials, metals, elemental filaments and the like.

The sheet resistance (ohms/sq) of the tin oxide film is measured with a conventional four point probe according to ASTM standard method F374-81.

The film thickness is measured by the beta-back-scatter method according to British Standards Institution method BS5411: Part 12, 1981, ISO 3543-1981.

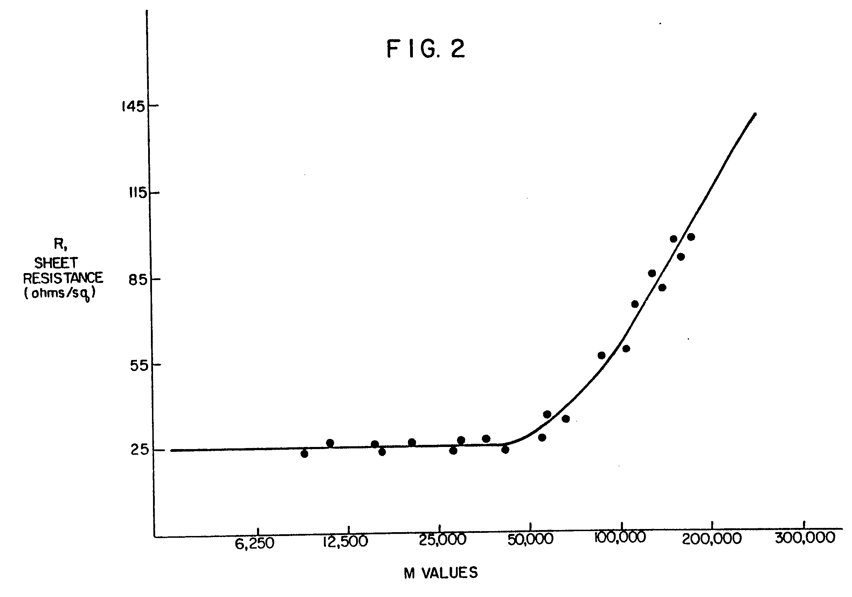

Referring now to Fig. 2, it is seen that the parameter M, which defines the process conditions of this invention, can be varied to provide fluorine-doped tin oxide coatings having a minimum and constant sheet resistance. For M values below 50,000, the sheet resistance of the coating, at a thickness of about 180 to 210 nm is 25 ohm/sq. For M values above 50,000, the sheet resistance increases rapidly with increasing M.

Example 1
Tin oxide coatings made under conditions in which the "M" value is below 50,000

A liquid coating composition of 100 parts monobutyltin trichloride (MBTC), 4.04 parts trifluoroacetic acid (TFA) and 1.45 parts acetic anhydride (AA) (specific gravity 1.62) was pumped at a rate of 10.5 g/hr, into an evaporator heated to 120°C, corresponding to 0.035 mol/hr of MBTC and 0.0035 mol/hr of TFA. Then wet air containing 28.8 mol/hr (835 g/hr) of air and 0.067 mol/hr (1.2 g/hr) of $H_2O$ was passed through the evaporator, and the vapor was deposited in 20 seconds onto a glass slide heated to 500°C. The coating thus produced had a thickness of 210 nm. The calculated M value was 16,000. The measured sheet resistance of the coating was 25 ohms/sq.

Example 2
Tin oxide coatings made under conditions in which the "M" value is above 50,000

A liquid coating composition of 100 parts MBTC, 2 parts TFA and 0.72 parts AA was pumped into the evaporator at a rate of 10.5 g/hr, corresponding to 0.036 mol/hr of MBTC and 0.0018 mol/hr of TFA. Then wet air containing 27.6 mol/hr (800 g/hr) of air and 1.02 mol/hr (18.4 g/hr) of $H_2O$ was passed through the evaporator and the vapor mixture thus-formed was deposited onto a glass slide heated to 500°C. In 12 seconds a fluorine-doped tin oxide coating having a thickness of 190 nm was produced. The calculated M value was $4.3 \times 10^5$. The measured sheet resistance of the coating was 239 ohms/sq.

Example 3

Following the procedure of Examples 1 and 2, small variations in the concentrations of MBTC, TFA, air and water corresponding to M values below and above 50,000 were tested and recorded in the graph of Fig. 2. Below 50,000 the sheet resistance was measured as substantially a minimum and constant value of about 30 ohms/sq, while for M values greater than 20,000, the sheet resistance was substantially higher, and increased rapidly with increasing M values.

The doped tin oxide coatings of the invention which are made within prescribed M values also are observed to have a minimum and constant sheet resistance over a wide range of deposition temperatures, whereas similar coatings made at higher M values (above 50,000) exhibit an increasing sheet resistance at different deposition temperatures.

While the invention has been described with reference to certain embodiments thereof, it will be understood that changes and modifications may be made which are within the skill of the art.

Claims

1. An improved chemical vapor deposition method of producing a fluorine-doped tin oxide coating which has a minimum and constant sheet resistance under different process conditions, comprising:

(a) forming a liquid coating composition which includes an organic fluorine dopant and an organotin compound, said composition comprising:

(1) 1—30 wt.% of an organic fluorine dopant wherein at least one fluorine atom is located alpha or beta to a functional group wherein carbon is bonded to oxygen selected from carboxylic acid, anhydride, ester, alcohol, ketone, acid halide, or ether; and

(2) 70—99 wt.% of an organotin compound, which is an alkyltin trichloride, a dialkyltin dichloride, an alkyldichlorotin acetate, a dialkylchlorotin diacetate, or an ester tin trichloride; or tin tetrachloride;

(b) vaporizing said liquid coating composition into a wet carrier gas to form a vapor mixture of carrier gas, water, organic fluorine dopant and organotin compound; and

(c) decomposing said vapor mixture on a substrate to form said coating, characterized in that:

the vapor concentrations of said components are such that a parameter M, defined as:

$$M = \frac{(AIR) \quad (H_2O)}{(OFD) \quad (O)}$$

where (AIR), (H₂O), (OFD) and (O) are the molar proportions of carrier gas, water, organic fluorine dopant and organotin compound in the vapor mixture, has a value of 50,000 or less, thereby to produce a fluorine-doped tin oxide coating having a minimum and constant sheet resistance for said values of M.

2. A process according to claim 1, wherein M has a value of 20,000 or less.

3. A process according to claim 1 or claim 2, in which the sheet resistance of the coating produced thereby is about 25 ohms/sq at a thickness of about 180—210 nm.

4. A process according to any preceding claim in which the liquid coating composition comprises 2—10 wt.% of said organic fluorine dopant, and 90—98% of said organotin compound.

5. A process according to any of claims 1 to 3, wherein said liquid coating composition includes up to 10 wt.% of a polar organic compound.

6. A process according to claim 5, wherein said composition includes 2—10 wt.% of said organic fluorine dopant, 80—97 wt.% of said organotin compound, and 1—10 wt.% of said polar organic compound.

7. A process according to claim 5 or claim 6, wherein said polar organic compound is acetic anhydride, ethyl acetate or methylisobutylketone.

8. A process according to any preceding claim, wherein said vaporization temperature is 100—400°C.

9. A process according to any preceding claim, wherein said deposition temperature is above 400° and below 700°C.

10. A process according to claim 1, wherein said substrate is glass.

11. A process according to any of claims 1 to 10, wherein said organotin compound is monobutyltin trichloride, methyltin trichloride, isobutyltin trichloride, dibutyltin dichloride, di-t-butyltin dichloride, butyldichlorotin acetate, butylchlorotin diacetate, or carbethoxyethyltin trichloride.

Patentansprüche

1. Verbessertes Verfahren zur chemischen Abscheidung aus der Dampfphase zur Herstellung einer mit Fluor dotierten Zinnoxidbeschichtung, die einen minimalen und konstanten Schichtwiderstand unter verschiedenen Prozeßbedingungen aufweist, umfassend:

(a) Bilden einer flüssigen Beschichtungszusammensetzung, die einen organischen Fluor-Dotierstoff und eine Organozinnverbindung enthält, wobei die genannte Zusammensetzung besteht aus:

(1) 1—30 Gew.-% eines organischen Fluor-Dotierstoffs, worin wenigstens ein Fluoratom in Alpha- oder Beta-Stellung zu einer funktionellen Gruppe angeordnet ist, worin Kohlenstoff an Sauerstoff gebunden ist und die aus Carbonsäure, Anhydrid, Ester, Alkohol, Keton, Säuerhalogenid oder Äther gewählt ist; und

(2) 70—99 Gew.-% einer Organozinnverbindung, die ein Alkylzinntrichlorid, ein Dialkylzinndichlorid, ein Alkyldichlorzinnacetat, ein Dialkylchlorzinndiacetat, oder ein Esterzinntrichlorid ist; oder Zinntetrachlorid;

(b) Verdampfen der genannten flüssigen Beschichtungszusammensetzung in ein feuchtes Trägergas, um eine Dampfmischung aus Trägergas, Wasser, organischem Fluor-Dotierstoff und Organozinnverbindung herzustellen; und

(c) Zersetzen des genannten Dampfgemisches auf einem Substrat, um die genannte Beschichtung zu bilden, dadurch gekennzeichnet, daß die Dampfkonzentrationen der genannten Bestandteile so gewählt sind, daß ein Parameter M, der als

$$M = \frac{(AIR) \quad (H_2O)}{(OFD) \quad (O)}$$

definiert ist, worin (AIR), (H₂O), (OFD) und (O) die molaren Mengenverhältnisse von Trägergas, Wasser, organischem Fluor-Dotierstoff und Organozinnverbindung im Dampfgemisch bedeuten, einen Wert von weniger als 50.000 hat, um dadurch eine mit Fluor dotierte Zinnoxidbeschichtung herzustellen, die einen minimalen und konstanten Schichtwiderstand für den genannten Wert von M aufweist.

2. Verfahren nach Anspruch 1, worin M einen Wert von 20.000 oder weniger aufweist.

3. Verfahren nach Anspruch 1 oder 2, in dem der Schichtwiderstand der danach hergestellten Beschichtung etwa 250 Ohm/Quadrat bei einer Dicke von etwa 180—210 nm beträgt.

4. Verfahren nach einem der vorhergehenden Ansprüche, in dem die flüssige Beschichtungszusammensetzung 2—10 Gew.-% des genannten organischen Fluor-Dotierstoffs und 90—98 Gew.-% der genannten Organozinnverbindung enthält.

5. Verfahren nach einem der Ansprüche 1 bis 3, worin die genannte flüssige Beschichtungszusammensetzung bis zu 10 Gew.-% einer polaren organischen Verbindung enthält.

6. Verfahren nach Anspruch 5, worin die genannte Zusammensetzung 2—10 Gew.-% des genannten organischen Fluor-Dotierstoffs, 80—97 Gew.-% der genannten Organozinnverbindung und 1—10 Gew.-% der genannten polaren organischen Verbindung enthält.

7. Verfahren nach Anspruch 5 oder 6, worin die genannte polare organische Verbindung Essigsäureanhydrid, Äthylacetat oder Methylisobutylketon ist.

8. Verfahren nach einem der vorhergehenden Ansprüche, worin die genannte Verdampfungstemperatur 100—400°C beträgt.

9. Verfahren nach einem der vorhergehenden Ansprüche, worin die genannte Abscheidungstemperatur mehr als 400°C und weniger als 700°C beträgt.

10. Verfahren nach Anspruch 1, worin das genannte Substrat Glas ist.

11. Verfahren nach einem der Ansprüche 1 bis 10, worin die genannte Organozinnverbindung Monobutylzinntrichlorid, Methylzinntrichlorid, Isobutylzinntrichlorid, Dibutylzinndichlorid, Di-tert.-butylzinndichlorid, Butyldichlorzinnacetat, Butylchlorzinndiacetat oder Carbäthoxyäthylzinntrichlorid ist.

**Revendications**

1. Méthode perfectionnée de dépôt chimique en phase vapeur pour produire un revêtement d'oxyde d'étain dopé au fluor qui a une résistance en feuille minimale et constante dans différentes conditions de procédé, consistant à:

(a) former une composition liquide de revêtement qui contient un fluor oganique dopant et un composé d'organoétain, ladite composition comprenant:

(1) 1—30% en poids d'un fluor dopant organique où au moins un atome de fluor est en position alpha ou bêta par rapport à un groupe fonctionnel où le carbone est lié à l'oxygène choisi parmi l'acide carboxylique, l'anhydride, l'ester, l'alcool, la cétone, l'halogénure d'acide ou l'éther; et

(2) 70—99% en poids d'un composé d'organoétain qui est un trichlorure d'alkylétain, un dichlorure de dialkylétain, un acétate d'alkyldichloroétain, un diacétate de dialkylchloroétain ou un trichlorure d'étain ester; ou bien du tétrachlorure d'étain;

(b) vaporiser ladite composition liquide de revêtement dans un gaz porteur humide pour former un mélange en vapeur du gaz porteur, de l'eau, du fluor organique dopant et du composé d'organétain; et

(c) décomposer ledit mélange en vapeur su un substrat pour former ledit revêtement, caractérisée en ce que:

les concentrations dans la vapeur desdits composants sont telles qu'on paramètre M, défini par

$$M = \frac{(AIR) \quad (H_2O)}{(OFD) \quad (O)}$$

où (AIR), (H₂O), (OFD) et (O) sont les proportions molaires du gaz porteur, de l'eau, du fluor organique

EP 0 186 481 B1

dopant et du composé d'organoétain dans la mélange en vapeur,
a une valeur de moins de 50.000, pour ainsi produire un revêtement d'oxyde d'étain dopé au fluor ayant une résistance en feuille minimale et constante pour lesdites valeurs de M.

2. Procédé selon la revendication 1 où M a une valeur de 20.000 au moins.

3. Procédé selon la revendication 1 ou la revendication 2 où la résistance en feuille du revêtement ainsi produit est d'environ 25 ohms/carré à une épaisseur d'environ 180—210 nm.

4. Procédé selon toute revendication précédente où la composition liquide de revêtement comprend 2—10% en poids dudit fluor organique dopant et 90—98% dudit composé d'organoétain.

5. Procédé selon l'une des revendications 1 à 3 où ladite composition liquide de revêtement contient jusqu'à 10% en poids d'un composé organique polaire.

6. Procédé selon la revendication 5 où ladite composition contient 2—10% en poids dudit fluor organique dopant, 80—97% en poids dudit composé d'organoétain et 1—10% en poids dudit composé organique polaire.

7. Procédé selon la revendication 5 ou la revendication 6 où ledit composé organique polaire est l'anhydride acétique, l'acétate d'éthyle ou la méthyl isobutyl cétone.

8. Procédé selon toute revendication précédente où ladite température de vaporisation est de 100—400°C.

9. Procédé selon toute revendication précédente où ladite température de dépôt est au delà de 400°C et inférieure à 700°C.

10. Procédé selon la revendication 1 où ledit substrat est du verre.

11. Procédé selon l'une des revendications 1 à 10 où ledit composé d'organoétain est le trichlorure de monobutylétain, le trichlorure de méthylétain, le trichlorure d'isobutylétain, le dichlorure de dibutylétain, le dichlorure de di-t-butylétain, l'acétate de butyldichloroétain, le diacétate de butylchloroétain ou le trichlorure de carboéthoxyéthylétain.

FIG. I

FIG. 2

R,
SHEET
RESISTANCE
(ohms/sq.)

M VALUES

EP 0 186 481 B1